# FASCICULE DE BREVET EUROPEEN

(11) **EP 2 868 171 B1**
(45) Date de publication et mention de la délivrance du brevet: **07.09.2016**
(21) Numéro de dépôt: 13724836.5
(22) Date de dépôt: 23.05.2013
(51) Int. Cl.: H05K 3/36, H05K 3/34

(54) **ENTRETOISE À BRASER ET MODULE ÉLECTRONIQUE COMPORTANT UNE TELLE ENTRETOISE**
ABSTANDSHALTER ZUM LÖTEN UND ELEKTRONISCHES MODUL UMFASSEND EINEN SOLCHEN ABSTANDSHALTER
SPACER TO BE BRAZED AND ELECTRONIC MODULE COMPRISING SUCH A SPACER

(30) Priorité: 27.06.2012 FR 1256100
(43) Date de publication de la demande: 06.05.2015
(73) Titulaire: SAGEMCOM BROADBAND SAS, 92500 Rueil Malmaison (FR)
(72) Inventeur: KOHN, Stéphane, F-92500 Rueil Malmaison (FR)
(74) Mandataire: Lavialle, Bruno François Stéphane
(86) Numéro de dépôt international: PCT/EP2013/060676
(87) Numéro de publication internationale: WO 2014/000999

(56) Documents cités:
- US-A- 5 008 777
- US-A1- 2009 175 015
- US-A1- 2010 122 458

## Description

L'invention concerne une entretoise à braser pour assembler deux cartes électroniques ou deux plaques quelconques. L'invention concerne également un module électronique comportant une telle entretoise.

### ARRIERE PLAN DE L'INVENTION

Dans les modules électroniques comportant plusieurs cartes électroniques, il est fréquent d'utiliser des entretoises pour assembler les cartes électroniques entre elles. Ces entretoises sont soit réalisées en matière plastique, soit réalisées en matière métallique, ces dernières permettant en outre d'assurer une continuité électrique entre les masses électriques des cartes électroniques.

Certaines entretoises, aussi appelées colonnettes, comportent un corps allongé ayant une extrémité taraudée définissant un taraudage, et un tronçon fileté s'étendant depuis l'autre extrémité du corps allongé.

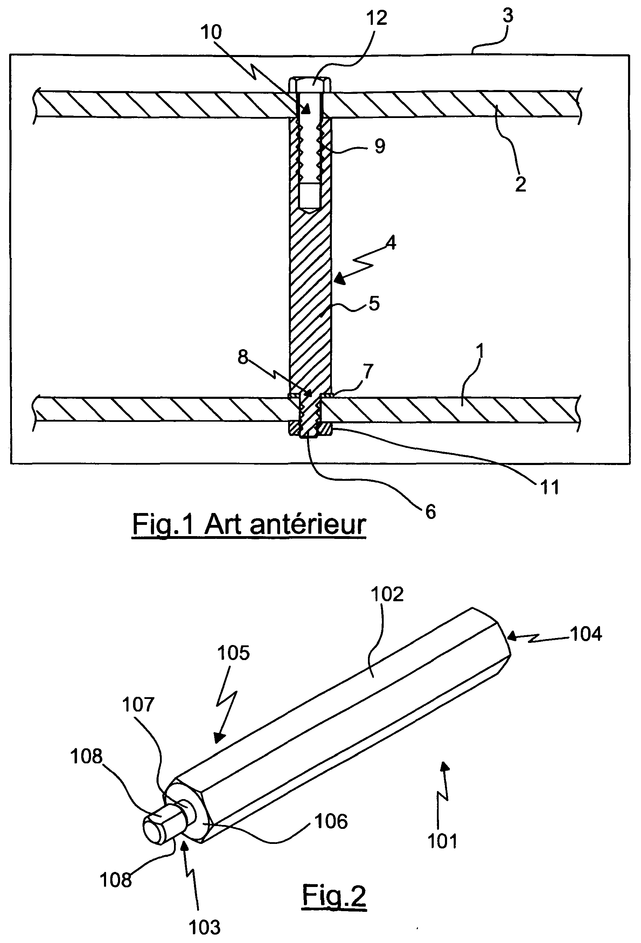

Sur la figure 1 est représentée une vue en coupe d'une première carte électronique 1 et d'une deuxième carte électronique 2 d'un module électronique 3, assemblées au moyen d'au moins une entretoise ou colonnette de l'art antérieur 4.

Le corps 5 de l'entretoise 4 est positionné entre les cartes 1, 2 de manière à ce que, d'une part, le tronçon fileté 6 saille de la première carte 1 au travers d'une rondelle 7 (optionnelle) et d'une ouverture 8 pratiquée dans la première carte 1 et, d'autre part, le taraudage 9 soit placé en regard d'une ouverture 10 pratiquée dans la deuxième carte 2. Un écrou 11 est vissé sur le tronçon fileté 6, et une vis 12 est vissée dans le taraudage 9 de l'entretoise 4 au travers de l'ouverture 10.

Cet assemblage nécessite l'utilisation d'un nombre important de composants (une vis, un écrou et une rondelle pour chaque entretoise), ce qui augmente le coût du module électronique et complexifie la gestion de sa nomenclature, des obsolescences, des approvisionnements, etc.

Pour supprimer l'écrou et la rondelle, il aurait pu être envisagé un assemblage dans lequel l'entretoise est fixée à la première carte par une opération de passage a la vague consistant à appliquer directement une pâte à braser sur le filetage de l'entretoise et sur une plage d'accueil de la première carte. Un premier inconvénient d'une telle fixation est sa faible tenue mécanique, due à une mauvaise tenue de la pâte à braser sur le filetage, qui limite un couple de serrage applicable à la vis s'étendant dans le taraudage. Un second inconvénient d'une telle fixation est une mauvaise reproductibilité de la tenue mécanique de la fixation, qui empêche de définir un couple de serrage unique pour toutes les entretoises, ce qui rend difficile la mise en oeuvre automatisée de l'assemblage.

L'état de l'art comprend en particulier les documents US-A1-2010/122458, US-A1-2009/175015 et US-A-5008777. L'invention se distingue de l'objet divulgué dans ce dernier document par les caractéristiques définies dans la partie caractérisante de la revendication 1.

### OBJET DE L'INVENTION

L'invention a pour objet de proposer une entretoise permettant un assemblage de deux cartes électroniques ou plaques diverses ne présentant pas les inconvénients précités.

### RESUME DE L'INVENTION

En vue de la réalisation de ce but, on propose une entretoise à braser comportant un corps allongé ayant une extrémité pourvue d'un taraudage et une extrémité opposée pourvue d'une surface transversale d'appui en saillie de laquelle s'étend un pion lisse de centrage, le pion comportant un passage extérieur longitudinal s'étendant sur au moins une partie de sa longueur jusqu'à la surface d'appui permettant une remontée par capillarité d'une pâte à braser en fusion jusqu'à la face d'appui.

Ainsi, au cours d'un assemblage de deux cartes électroniques ou plaques diverses, la fixation de l'entretoise à la première carte est réalisée par une opération de brasage réalisée au niveau du pion de centrage. Cette fixation ne requiert donc plus l'utilisation d'une rondelle et d'un écrou. Le passage extérieur longitudinal permet à une certaine quantité de pâte à braser de remonter vers la surface d'appui, permettant à une relativement grande surface de l'entretoise d'être en contact avec la brasure. Or, la résistance de la fixation est proportionnelle à la surface en contact avec la brasure. L'invention permet ainsi une fixation efficace, ce qui a pour effet, d'une part, d'augmenter le couple de serrage admissible d'une vis s'étendant dans le taraudage du corps, et d'autre part, d'améliorer la reproductibilité de la tenue mécanique de cette fixation et donc de permettre l'automatisation de l'assemblage.

L'invention concerne également un module comportant une telle entretoise.

L'invention sera mieux comprise à la lumière de la description qui suit d'un mode de mise en oeuvre particulier non limitatif de l'invention.

### BREVE DESCRIPTION DES DESSINS

Il sera fait référence aux dessins annexés, parmi lesquels :
- la figure 1 a été décrite ci-avant ;
- la figure 2 est une vue en perspective d'une entretoise à braser de l'invention ;
- la figure 3 est une vue en coupe de deux cartes électroniques assemblées au moyen d'une entretoise à braser de l'invention ;
- la figure 4 est une vue en coupe d'un pion de centrage d'une entretoise à braser de l'invention et d'une carte électronique, selon un plan de coupe A-A transverse de la figure 3.

### DESCRIPTION DETAILLEE DE L'INVENTION

En référence à la figure 2, une entretoise à braser 101 de l'invention comporte un corps allongé 102 de section transversale hexagonale et un pion de centrage 103 de forme générale cylindrique. Le corps allongé 102 comporte une extrémité taraudée 104 et une extrémité opposée 105 pourvue d'une surface transversale d'appui 106, en saillie de laquelle s'étend le pion de centrage 103 coaxialement au corps allongé 102. Le pion de centrage 103 se raccorde à la surface transversale d'appui 106 par une gorge circulaire 107. Le pion de centrage 103 est muni de deux méplats extérieurs 108 longitudinaux disposés symétriquement.

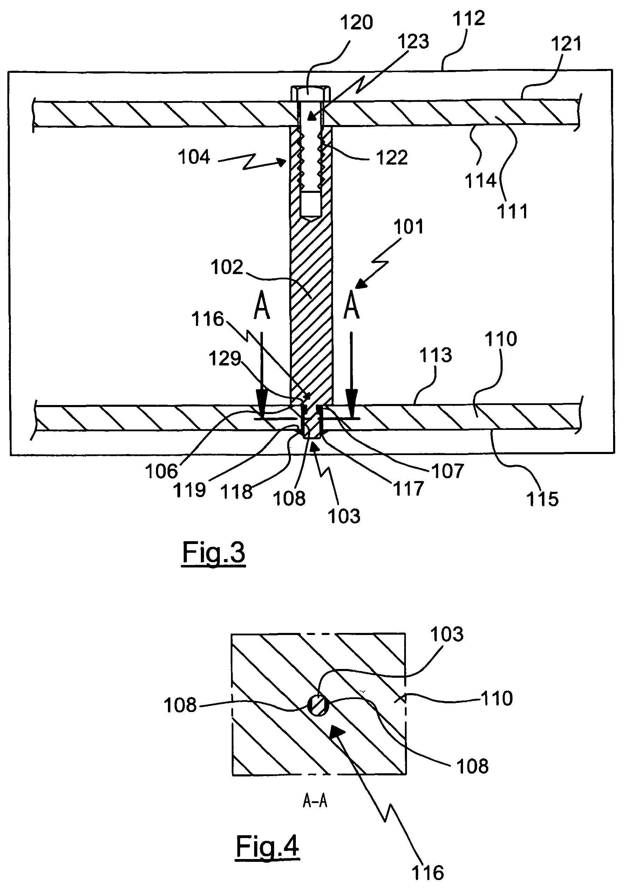

En référence aux figures 3 et 4, l'entretoise à braser 101 de l'invention est ici utilisée pour assembler une première carte électronique 110 et une deuxième carte électronique 111 d'un module électronique 112. Le corps allongé 102 de l'entretoise à braser 101, monté entre une face interne 113 de la première carte 110 et une face interne 114 de la deuxième carte 111, permet de maintenir espacées les deux cartes 110, 111.

L'entretoise 101 est disposée sur la première carte 110 de manière à ce que la surface transversale d'appui 106 soit en appui sur la face interne 113 de la première carte 110, et à ce que le pion de centrage 103 saille au niveau d'une face externe 115 de la première carte 110 au travers d'une ouverture 116 pratiquée dans la première carte 110.

La fixation par laquelle l'entretoise 101 et la première carte 110 sont solidarisées est réalisée par une méthode de brasage quelconque (brasage au four, à la vague, manuelle, etc.). De la pâte à braser est appliquée au niveau d'une extrémité libre 117 du pion 103. La pâte à braser (pouvant par exemple contenir de l'étain dans une certaine proportion) en fusion remonte par capillarité en direction de la gorge 107 de l'entretoise 101 en passant par un espace situé dans l'ouverture 116 et défini par les méplats 108. Une première quantité de pâte à braser en fusion 118 s'étale en recouvrant une plage d'accueil 119 entourant l'ouverture 116 de la première carte au niveau de la face externe 115 de la première carte 110. Une seconde quantité de pâte à braser 129 en fusion vient remplir la gorge 107 de l'entretoise 101 jusqu'à la surface transversale d'appui 106. La gorge 107 permet une application uniforme de pâte à braser sur la surface transversale d'appui 106, formant ainsi une fixation présentant une tenue mécanique importante et reproductible à toute entretoise similaire équipant un module électronique quelconque.

La fixation par laquelle l'entretoise et la seconde carte 111 sont solidarisées l'une à l'autre est réalisée par le vissage d'une vis 120 s'étendant depuis une face externe 121 de la deuxième carte 111 jusqu'au taraudage 122 de l'extrémité taraudée 104 de l'entretoise 101 au travers d'une ouverture 123 pratiquée dans la deuxième carte 111. L'ouverture 116 pratiquée dans la première carte 110 et celle 123 pratiquée dans la deuxième carte 111 sont positionnées en regard l'une de l'autre.

Le pion de centrage 103 permet de centrer l'entretoise 101 dans l'ouverture 116 de la première carte 110 pour assurer une tolérance de montage suffisante permettant un vissage aisé de la vis 120 dans le taraudage 122.

La robustesse et la reproductibilité de la fixation au niveau de la première carte 110 autorisent un couple de serrage important de la vis 120 dans le taraudage 122 au niveau de la deuxième carte 111, et permettent de définir un couple de serrage identique pour toute vis associée à une telle entretoise, ce qui facilite l'automatisation d'un montage tel que celui décrit ci-dessus.

L'invention n'est pas limitée au mode de réalisation particulier qui vient d'être décrit, mais, bien au contraire, couvre toute variante entrant dans le cadre de l'invention telle que définie par les revendications.

Bien que l'on ait muni le pion de centrage de méplats symétriques, il est possible de prévoir un passage longitudinal extérieur différent, comportant par exemple une ou plusieurs rainures agencées de telle manière que le pion de centrage puisse continuer à assurer sa fonction de centrage de l'entretoise par rapport à la carte.

Le corps peut avoir une section transversale autre qu'hexagonale, comme une section polygonale carrée, cylindrique ou autre.

Bien que l'on ait choisi d'illustrer l'invention en utilisant une entretoise à braser de l'invention pour assembler deux cartes électroniques d'un module électronique, il est possible d'utiliser une telle entretoise pour assembler tout type d'élément comprenant une partie plane que l'on souhaite maintenir espacée d'une autre partie plane.

## Revendications

1. Entretoise à braser comportant un corps allongé (102) ayant une extrémité pourvue d'un taraudage (104) et une extrémité opposée pourvue d'une surface transversale d'appui (106) en saillie de laquelle s'étend un pion lisse de centrage (103), **caractérisé, en ce que** le pion (103) comporte un passage extérieur longitudinal (108) s'étendant sur au moins une partie de sa longueur jusqu'à la surface transversale d'appui (106) permettant une remontée par capillarité d'une pâte à braser en fusion jusqu'à la surface transversale d'appui (106).

2. Entretoise à braser selon la revendication 1, dans laquelle le pion (103) se raccorde à la surface transversale d'appui (106) par une gorge circulaire (107).

3. Entretoise à braser selon la revendication 1, dans laquelle le passage extérieur (108) comporte au moins un méplat (108).

4. Entretoise à braser selon la revendication 1, dans laquelle le passage extérieur (108) comporte deux méplats (108) symétriques.

5. Module électronique (112) comportant deux cartes électroniques (110, 111) maintenues espacées par une entretoise (101) conforme à l'une des revendications 1 à 4, dans lequel l'entretoise (101) est fixée à une carte électronique (111) par coopération d'une vis (120) et de l'extrémité pourvue d'un taraudage (104), et l'entretoise (101) est fixée à l'autre carte (110) par une brasure reliant le pion (103) à la carte (110) et remontant le long du pion (103) par le passage extérieur longitudinal (108) jusqu'à la surface transversale d'appui (106).

## Patentansprüche

1. Abstandshalter zum Löten, umfassend einen länglichen Körper (102), der ein mit einem Innengewinde (104) versehenes Ende und ein entgegengesetztes Ende hat, das mit einer transversalen Anlagefläche (106) versehen ist, von der ein glatter Zentrierzapfen (103) vorsteht, **dadurch gekennzeichnet, dass** der Zapfen (103) einen länglichen äußeren Durchlass (108) umfasst, der sich auf mindestens einem Teil seiner Länge bis zur transversalen Anlagefläche (106) erstreckt und ein Aufsteigen einer Lötpaste im geschmolzenen Zustand mittels Kapillareffekt bis zur transversalen Anlagefläche (106) ermöglicht.

2. Abstandshalter zum Löten nach Anspruch 1, wobei sich der Zapfen (103) über eine ringförmige Nut (107) an die transversale Anlagefläche (106) anschließt.

3. Abstandshalter zum Löten nach Anspruch 1, wobei der äußere Durchlass (108) mindestens eine Flachstelle (108) umfasst.

4. Abstandshalter zum Löten nach Anspruch 1, wobei der äußere Durchlass (108) zwei symmetrische Flachstellen (108) umfasst.

5. Elektronisches Modul (112), umfassend zwei Leiterplatten (110, 111), die durch einen Abstandshalter (101) gemäß einem der Ansprüche 1 bis 4 beabstandet gehalten werden, wobei der Abstandshalter (101) an einer Leiterplatte (111) durch Zusammenwirken einer Schraube (120) mit dem mit einem Innengewinde (104) versehenen Ende befestigt ist und der Abstandshalter (101) an der anderen Leiterplatte (110) durch ein Lötmaterial befestigt ist, das den Zapfen (103) mit der Leiterplatte (110) verbindet und entlang des Zapfens (103) über den länglichen äußeren Durchlass (108) bis zu der transversalen Anlagefläche (106) aufsteigt.

## Claims

1. A spacer for soldering comprising an elongate body (102) having one end provided with a tapped hole (104) and an opposite end provided with a transverse bearing surface (106) having a smooth centering peg (103) projecting therefrom, the peg (103) has a longitudinal outer passage (108) extending over at least a fraction of its length as far as the transverse bearing surface (106) to enable molten solder to penetrate by capillarity as far as the transverse bearing surface (106).

2. A spacer for soldering according to claim 1, wherein the peg (103) is connected to the transverse bearing surface (106) via a circular groove (107).

3. A spacer for soldering according to claim 1, wherein the outer passage (108) includes at least one flat (108).

4. A spacer for soldering according to claim 1, wherein the outer passage (108) has two symmetrical flats (108).

5. An electronics module (112) having two electronics cards (110, 111) that are held spaced apart by a spacer (101) according to any one of claims 1 to 4, wherein the spacer (101) is fastened to one electronics card (111) by co-operation between a bolt (120) and the end provided with a tapped hole (104), and the spacer (101) is fastened to the other card (110) via solder connecting the peg (103) to the card (110) and penetrating along the peg (103) via the longitudinal outer passage (108) to the transverse bearing surface (106).
